# EUROPEAN PATENT APPLICATION

(11) **EP 4 589 832 A1**
(43) Date of publication of application: **23.07.2025**
(21) Application number: 22958562.5
(22) Date of filing: 09.10.2022
(51) Int. Cl.: H02M 7/42

(54) **POWER CONVERTER AND AUTOMATIC DUST CLEANING METHOD**

(30) Priority: 13.09.2022 CN 202211119013
(71) Applicant: Sungrow Power Supply Co., Ltd., Hefei, Anhui 230088 (CN)
(72) Inventor: YU, Renbin, Hefei, Anhui 230088 (CN); XU, Anan, Hefei, Anhui 230088 (CN); YANG, Ye, Hefei, Anhui 230088 (CN)
(74) Representative: Zacco Norway AS
(86) International application number: PCT/CN2022/123967
(87) International publication number: WO 2024/055372

(57) **Abstract**

Disclosed in the present application are a power converter and an automatic dust cleaning method. The power converter comprises a power semiconductor device, a heat sink, a fan and a controller, wherein the heat sink comprises a heat sink substrate and a heat sink fin; the power semiconductor device is fitted on the heat sink substrate; an air inlet mesh, the fan, the heat sink and an air outlet mesh are sequentially arranged in a box body of the power converter; air channels are formed between the fan and the heat sink and between the heat sink and the air outlet mesh; and the controller is configured to control, when the power converter is in a non-grid-connected state, the fan to run backwards for self-cleaning of the power converter. Since the present application implements, when the power converter is in the non-grid-connected state, control over the fan for self-cleaning of the power converter, normal operation of the power converter is not affected, such that the operating efficiency of the power converter is not reduced.

## Description

The present application claims the priority to Chinese Patent Application No. 202211119013.1, titled "POWER CONVERTER AND AUTOMATIC DUST CLEANING METHOD", filed on September 13, 2022 with the China National Intellectual Property Administration, which is incorporated herein by reference in its entirety.

### FIELD

The present application relates to the technical field of electrical equipment, and in particular to a power converter and a method for cleaning dust automatically.

### BACKGROUND

With the continuous development of electrical technology, the power converter, as an AC/DC conversion device, is widely used in data communication, computer, the industrial engineering, aerospace and other fields. The power converter often use air cooling to dissipate heat, that is, a fan draws in external cold air through the air inlet and blows the external cold air to the heat sink to remove heat. However, during the air cooling process, the problem of blockage caused by the accumulation of foreign objects such as sucked dust affects the heat dissipation effect. Failure to dissipate heat properly may result a decrease in the working efficiency of the power converter and even a risk of failure of the entire device. Therefore, clearing foreign objects from the air channel is an important part for maintaining the normal operation of the power converter.

At present, the main measure to clear the blockage of power converters is to perform maintenance and cleaning manually and regularly. This measure requires personnel to go to the site, which cannot be performed in time. In addition, manual maintenance and cleaning also has the disadvantages of long time and high cost of the maintenance.

### SUMMARY

In view of this, a power converter and a method for automatically cleaning dust are provided according to the present application, which can automatically clean the inside of the power converter without affecting the normal operation of the power converter.

To solve the above problems, a power converter is provided according to the present application. The power converter includes: a power semiconductor device, a heat sink, a fan and a controller;
the heat sink includes a heat sink substrate and heat sink fins;
the power semiconductor device is fitted on the heat sink substrate;
an air inlet mesh, a fan, a heat sink and an air outlet mesh are arranged in sequence in the box of the power converter; an air channel is formed between the fan and the heat sink and between the heat sink and the air outlet mesh; and
the controller is configured to, when the power converter is not in the grid-connected state, control the fan to rotate reversely for self-cleaning of the power converter.

Preferably, the controller is configured to control the fan to rotate reversely with a predetermined period and predetermine a time duration for each reverse rotation.

Preferably, the controller is configured to, when the time from the last reverse rotation of the fan is greater than or equal to a first interval, control the fan to rotate reversely for a predetermined time duration, then control the fan to stop and update the time from the last reverse rotation of the fan.

Preferably, the controller is configured to, when the total time duration of the fan reverse rotation is greater than or equal to a predetermined time duration, control the fan to rotate reversely with a predetermined period; when the total time duration of the fan reverse rotation is less than a predetermined time duration, control the fan to rotate reversely again with a time interval smaller than the predetermined period.

Preferably, the controller is configured to, when the total number of the fan reverse rotation is greater than or equal to the predetermined number of times, control the fan to rotate reversely with a predetermined period; when the total number of the fan reverse rotation is less than the predetermined number of times, control the fan to rotate reversely again with a time interval smaller than the predetermined period.

Preferably, the controller is configured to, when the total time duration of the fan reverse rotation is greater than or equal to a predetermined time duration and the total number of the fan reverse rotation is greater than or equal to the predetermined number of times, control the fan to rotate reversely with a predetermined period; when the total duration of the fan reverse rotation is less than a predetermined time duration and the total number of the fan reverse rotation is less than the predetermined number of times, control the fan to rotate reversely again with a time interval smaller than the predetermined period.

Preferably, the controller is configured to, when the inverter in the power converter is connected to the grid, control the fan to rotate reversely according to the power and/or current of the inverter.

Preferably, the controller is configured to, when the power converter starts, control the fan to rotate reversely for consuming energy and determine whether the energy at the input terminal of the inverter meets the requirements for grid connection.

A method for automatically cleaning dust of a power converter is further provided according to the present application. The power converter includes: a power semiconductor device, a heat sink and a fan; the heat sink includes a heat sink substrate and heat sink fins; the power semiconductor device is fitted on the heat sink substrate; an air inlet mesh, the fan, the heat sink and an air outlet mesh are arranged in sequence in the box of the power converter; and an air channel is formed between the fan and the heat sink and between the heat sink and the air outlet mesh.

The method for automatically cleaning dust of a power converter includes: determining the operation state of the power converter; and when the operation state of the power converter is non-grid-connected, controlling the fan to rotate reversely for self-cleaning of the power converter.

Preferably, controlling the fan to rotate reversely when the operation state of the power converter is not grid-connected includes: when the operation state of the power converter is non-grid-connected, controlling the fan to rotate reversely with a predetermined period and predetermining a time duration for each reverse rotation.

Preferably, controlling the fan to rotate reversely includes: when the time from the last reverse rotation of the fan is greater than or equal to a first interval, controlling fan to rotate reversely for a predetermined duration, then controlling the fan to stop and updating the time from the last reverse rotation.

Preferably, controlling the fan to rotate reversely includes: when the total time duration of the fan reverse rotation is greater than or equal to a predetermined time duration, controlling the fan to rotate reversely with a predetermined period; and when the total time duration of the fan reverse rotation is less than a predetermined time duration, controlling the fan to rotate reversely again with a time interval smaller than the predetermined period.

Preferably, controlling the fan to rotate reversely includes: when the total number of the fan reverse rotation is greater than or equal to the predetermined number of times, controlling the fan to rotate reversely with a predetermined period; and when the total number of the fan reverse rotation is less than the predetermined number of times, controlling the fan to rotate reversely again with a time interval smaller than the predetermined period.

Preferably, controlling the fan to rotate reversely includes: when the total time duration of the fan reverse rotation is greater than or equal to a predetermined time duration and the total number of the fan reverse rotation is greater than or equal to the predetermined number of times, controlling the fan to rotate reversely with a predetermined period; and when the total time duration of the fan reverse rotation is less than a predetermined time duration and the total number of the fan reverse rotation is less than the predetermined number of times, controlling the fan to rotate reversely again with a time interval smaller than the predetermined period.

Preferably, the method for automatically cleaning dust of a power converter further includes: when the inverter in the power converter is connected to the grid, controlling the fan to rotate reversely according to the power and/or current of the inverter.

Preferably, controlling the fan to rotate reversely according to the power and/or current of the inverter includes: when the power of the inverter is less than a predetermined power and/or the current of the inverter is less than a predetermined current, controlling the fan to rotate reversely.

Preferably, the method for automatically cleaning dust of a power converter further includes: when the power converter starts, controlling the fan to rotate reversely for consuming energy and determining whether the energy at the input terminal of the inverter meets the requirements for grid connection.

It can be seen that the present application has the following beneficial effects.

The controller in the power converter controls the fan to rotate reversely when the power converter is in the non-grid-connected state and blows out foreign objects such as dust inside the power converter for automatic cleaning, saving manpower and reducing the hysteresis of the manual cleaning. The present application controls the fan to self-clean the power converter when the power converter is not in the grid-connected state, not affecting the normal operation of the power converter, thereby not reducing the working efficiency of the power converter. Moreover, it is simple and easy to use the fan already in the power converter for heat dissipation without additional hardware equipment.

### BRIEF DESCRIPTION OF THE DRAWINGS

FIG. 1 is a three-dimensional schematic diagram of a power converter;
FIG. 2 is a left sectional view corresponding to FIG. 1;
FIG. 3 is a bottom view corresponding to FIG. 1;
FIG. 4 is a schematic diagram of a power converter provided according to the embodiment of the present application;
FIG. 5 is a flowchart of a method for automatically cleaning dust of a power converter provided according to the embodiment of the present application;
FIG. 6 is a flowchart of another method for automatically cleaning dust of a power converter provided according to the embodiment of the present application; and
FIG. 7 is a flowchart of a further method for automatically cleaning dust of a power converter provided according to the embodiment of the present application.

### DETAILED DESCRIPTION OF EMBODIMENTS

In order to make each of the embodiments of the present application more clearly to be understood, the heat dissipation principle of the power converter is briefly described below.

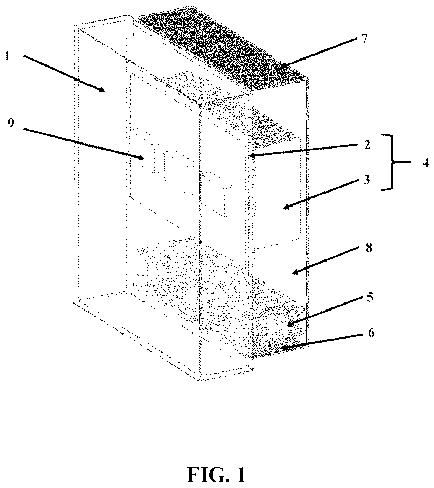

Reference is made to FIG. 1, and FIG. 1 is a three-dimensional schematic diagram of a power converter.

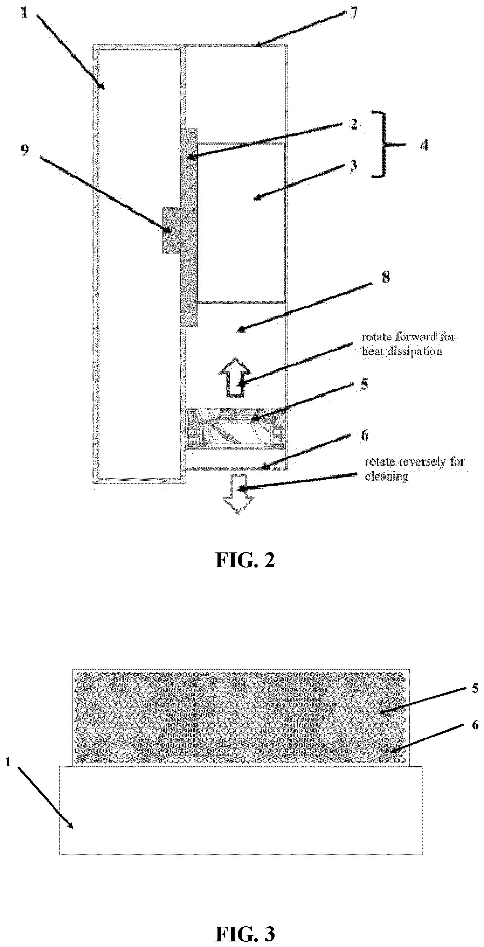

Reference is made to FIG. 2, and FIG. 2 is a left sectional view corresponding to FIG. 1.

Reference is made to FIG. 3, and FIG. 3 is a bottom view corresponding to FIG. 1.

A power converter includes the following parts: a front box 1, a heat sink 4, a fan 5, an air inlet mesh 6, an air outlet mesh 7, an air channel 8 and a power semiconductor device 9. The heat sink 4 consists of a heat sink substrate 2 and heat sink fins 3.

The power semiconductor device 9 is arranged in the front box 1 and fitted to the heat sink substrate 2 through an interface material; heat generated by the power semiconductor device 9 in the front box 1 is transferred to the heat sink fins 3 through the heat sink substrate 2; the fan 5 draws in the external cold air from the air inlet mesh 6, and then blows the cold air to the heat sink fins 3 to dissipate the heat; and the generated hot air is discharged to the external environment through the air outlet mesh 7.

However, during the heat dissipation process of the fan 5, negative pressure may be formed at the air inlet mesh 6, which easily draws foreign objects such as cotton wool and dust in the air into the air channel 8, further causing the air inlet mesh 6, the heat sink fins 3 and other components to be blocked, and the heat dissipation is affected.

The manual regular cleaning method has high maintenance costs and cannot be performed in time. The technical solution provided according to the embodiments of the present application can, when the power converter is not in the grid-connected state, control the fan to rotate reversely to blow out foreign objects such as dust for automatically cleaning the inside of the power converter, saving manpower and reducing hysteresis. Since controlling the fan to self-clean the power converter according to the present application is performed when the power converter is in a non-grid-connected state, a normal operation of the power converter is not affected.

In order to make the above objectives, features and advantages of the present application more obvious and easier to be understood, the embodiments of the present application are described in further detail below in conjunction with the drawings and embodiments.

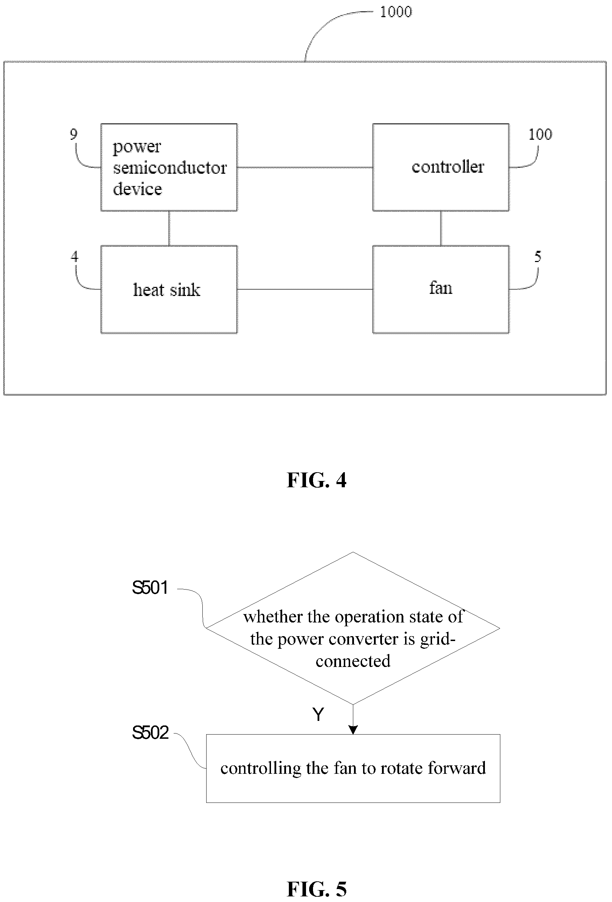

Reference is made to FIG. 4, and FIG. 4 is a schematic diagram of a power converter provided according to the embodiment of the present application.

A power converter 1000 provided according to the embodiment includes: the power semiconductor device 9, the heat sink 4, the fan 5 and the controller 100.

Reference is further made to FIG. 1.

The heat sink 4 includes the heat sink substrate 2 and the heat sink fins 3; and the power semiconductor device 9 is fitted to the heat sink substrate 2.

The air inlet mesh 6, the fan 5, the heat sink 4 and the air outlet mesh 7 are arranged in sequence in the case of the power converter 1000; an air channel 8 is formed between the fan 5 and the heat sink 4 and between the heat sink 4 and the air outlet mesh 7.

In the embodiments of the present application, the specific topology and application scenarios of the power converter are not limited. For example, the power converter can be applied to a photovoltaic system, an energy storage system, a new energy vehicle and the like. The power converter can be a DCDC converter, a DCAC converter, or an ACDC converter. The power semiconductor device inside the power converter can be any of a metal oxide semiconductor field effect transistor MOS, an insulated gate bipolar transistor IGBT and the like.

In the present application, the specific type of the power semiconductor device is not limited, and the power semiconductor device can also be other than those mentioned above.

The controller 100 is configured to, when the power converter is in a non-grid-connected state, control the fan to rotate reversely for self-cleaning the power converter.

When the power converter is in a non-grid-connected state, the fan 5 is controlled to rotate reversely, not affecting the normal operation of the power converter, not consuming the total power generation and also blowing foreign object, such as dust inside the power converter 1000, out for automatic cleaning.

With the power converter provided according to the embodiments of the present application, the controller, when the power converter is in a non-grid-connected state, controls the fan to rotate reversely and blow foreign object such as dust inside the power converter out, achieving automatic cleaning, saving manpower and reducing the hysteresis of manual cleaning; since controlling the fan to self-clean the power converter according to the present application is performed when the power converter is in a non-grid-connected state, the normal operation of the power converter is not affected.

In the embodiments of the present application, the specific implementation methods of the fan reverse rotation are not limited. For example, the time duration, the number of times, and the interval of the fan reverse rotation are not limited. The implementation methods of the fan reverse rotation are described in detail with examples below.

### The first implementation method

A controller is configured to, when the power converter is in a non-grid-connected state, control a fan to rotate reversely with a predetermined period and predetermine a time duration for each reverse rotation. For example, the predetermined period is 1 hour, that is, the fan rotates reversely once every 1 hour; the predetermined time duration is 10 minutes, that is, the fan needs to be rotating reversely for 10 minutes each time the fan rotate reversely. In the embodiments of the present application, the length of the predetermined period and the predetermined time duration are not limited. Those skilled in the art can set the length of the predetermined period and the predetermined time duration according to the actual needs of the self-cleaning.

The controller can set a minimum time interval ta, referred to as a first interval ta, between two adjacent fan reverse rotation. The controller can, when the time t1 from the last reverse rotation of the fan is greater than or equal to ta, control the fan to rotate reversely, control the fan to stop rotating reversely after a predetermined time duration tb and update the time t1 from the last reverse rotation.

In a case that the time t1 from the last reverse rotation of the fan is greater than or equal to ta, the predetermined period has been reached and a new self-cleaning is required, and the controller is needed to control the fan to rotate reversely for the next time.

The predetermined time duration tb for each reverse rotation can be same or different; the fan can be controlled to rotate reversely by setting a predetermined period, or not according to the predetermined period.

With the power converter provided according to the embodiments of the present application, the fan can also be controlled to rotate reversely only when the time from the last reverse rotation reaches the first interval ta, and each reverse rotation is performed for a predetermined time duration tb. The predetermined period consists of the first interval ta and predetermined time duration tb together. Those skilled in the art can adjust the frequency of the fan reverse rotation according to the predetermined period, reduce the predetermined period and increase the frequency of the fan reverse rotation in a case with a large demand for self-cleaning; and increase the predetermined period and reduce the frequency of the fan reverse rotation in a case with a small demand for self-cleaning, saving electricity, being able to adapt to different scenarios and being more flexible.

### The second implementation method

The controller can, in a case that the power converter is in a non-grid-connected state, set a predetermined time duration tc; when the total time duration t2 of the fan reverse rotation is greater than or equal to the predetermined time duration tc, the fan is controlled to rotate reversely with a predetermined period; when the total time duration t2 of the fan reverse rotation is less than the predetermined time duration tc, the fan is controlled to rotate reversely again with a time interval smaller than the predetermined period. The controller can also, in a case that the power converter is in a non-grid-connected state, set a predetermined number of times N; when the total number n of the fan reverse rotation is greater than the predetermined number of times N, the fan is controlled to rotate reversely with a predetermined period; when the total number n of the fan reverse rotation is less than the predetermined number of times N, the fan is controlled to rotate reversely again with a time interval smaller than the predetermined period.

In a case that the total time duration t2 of the reverse rotation is greater than or equal to the predetermined time duration tc or the total number n of the reverse rotation is greater than or equal to the predetermined number of times N, the self-cleaning degree of the fan reverse rotation has reached a predetermined standard and then self-cleaning can be performed according to the predetermined period. In a case that the total time duration t2 of the reverse rotation is less than the predetermined time duration tc or the total number n of the reverse rotation n is less than the predetermined number of times N, the self-cleaning degree of the fan reverse rotation has not reached the predetermined standard, so the fan is controlled to rotate reversely again with a time interval smaller than the predetermined period to improve the self-cleaning efficiency.

Both, only one or neither of the predetermined time duration tc and the predetermined number of times N can be set.

With the power converter provided according to the embodiments of the present application, multiple reverse rotation can also be implemented during the process of reverse rotation, that is, when the total time duration of the reverse rotation and/or the total number of the reverse rotation have not been reached, multiple reverse rotation of the fan can be performed within a shorter interval without waiting for the next period for reverse rotation to arrive, making it easier to remove foreign object, improving the efficiency of automatic cleaning and being suitable for applications in scenarios with high self-cleaning requirements.

In addition, the controller can, when the inverter in the power converter is connected to the grid, control the fan to rotate reversely according to the power and/or the current of the inverter.

When the power converter is grid-connected, based on the power and/or the current of the inverter, it is obtained that the fan is controlled to rotate reversely without affecting the normal operation of the power converter; at this time, the fan can also be controlled to rotate reversely for self-cleaning without affecting the normal operation of the power converter.

The controller can, when the power converter starts, control the fan to rotate reversely for consuming energy and determine whether the energy at the input terminal of the inverter meets the requirements for grid connection.

When it is detected whether the input energy at the input terminal of the inverter meets the requirements for grid connection, the energy consumed by the fan rotating for a period of time is usually used for making a determination. At this time, the fan can be controlled to rotate reversely for not only determining whether the input energy meets the requirements, but also performing the self-cleaning of the reverse rotation, saving steps.

Based on the power converter provided according to the above embodiments, a control method of the power converter further provided according to the embodiments of the present application is described in detail below in conjunction with the drawings.

Reference is made to FIG. 5, and FIG. 5 is a flowchart of a method for automatically cleaning dust of a power converter provided according to the embodiment of the present application.

A method for automatically cleaning dust of a power converter provided according to the embodiments of the present application is applied to the power converter described in the above embodiments, and the power converter includes: a power semiconductor device, a heat sink, and a fan; the heat sink includes a heat sink substrate and heat sink fins; the power semiconductor device is fitted to the heat sink substrate; and an inlet mesh, the fan, the heat sink, and an outlet mesh are arranged in sequence in the box of the power converter; an air channel is formed between the fan and the heat sink and between the heat sink and the air outlet mesh.

The method includes step S501 and step S502.

S501: determining whether an operation state of the power converter is grid-connected, and if the operation state of the power converter is not grid-connected, performing step S502.

S502: controlling the fan to rotate reversely when the power converter is in a non-grid-connected state to self-clean the power converter.

That controlling the fan to rotate reversely includes:
in a case that the power converter is in a non-grid-connected state, controlling the fan to rotate reversely with a predetermined period and predetermining a time duration for each reverse rotation; or
in a case that the power converter in the power converter is in a grid-connected state, when the power of the inverter is less than a predetermined power and/or the current of the inverter is less than a predetermined current, controlling the fan to rotate reversely.

The method for automatically cleaning dust of a power converter can further includes:
in a case that the power converter starts, controlling the fan to rotate reversely to consume energy and determining whether the energy at the input terminal of the inverter satisfies the requirements for grid connection.

With the method for automatically cleaning dust of a power converter provided according to the embodiments of the present application, when the power converter is in a non-grid-connected state, the fan is controlled to rotate reversely to blow out the dust and other foreign object inside the power converter for automatic cleaning, saving manpower and reducing the hysteresis of manual cleaning; since controlling the fan to self-clean the power converter according to the present application is performed when the power converter is in a non-grid-connected state, the normal operation of the power converter is not affected.

In the above method for automatically cleaning dust of the power converter, the fan can be controlled to rotate reversely according to multiple methods, and each of the different control methods is described below in conjunction with the drawings.

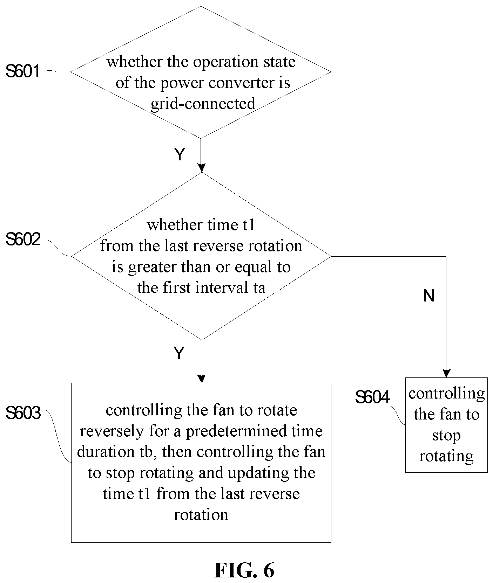

In an embodiment of the present application, the fan is periodically controlled to rotate reversely by setting a first interval ta. Reference is made to FIG. 6, and FIG. 6 is a flowchart of another method for automatically cleaning dust of a power converter provided according to the embodiment of the present application.

S601: determining whether the operation state of the power converter is grid-connected, and if the operation state of the power converter is grid-connected, performing step S602.

S602: determining whether the time t1 from the last reverse rotation of the fan is greater than or equal to the first interval ta, if t1is greater than or equal to ta, performing step S603; and if t1is less than ta, performing step S604.

S603: when the time t1 from the last reverse rotation of the fan is greater than or equal to the first interval ta, controlling the fan to rotate reversely for a predetermined time duration tb, then controlling the fan to stop and updating the time t1 from the last reverse rotation.

S604: controlling the fan to stop rotating.

With the method for automatically cleaning dust of a power converter provided according to the above embodiment of the present application, the fan can be controlled to rotate reversely only when the time from the last reverse rotation reaches the first interval ta, and each reverse rotation is performed for a predetermined time duration tb. The predetermined period consists of the first interval ta and predetermined time duration tb together. Those skilled in the art can adjust the frequency of the fan reverse rotation according to the predetermined period, reduce the predetermined period and increase the frequency of the fan reverse rotation in a case with a large demand for self-cleaning; and increase the predetermined period and reduce the frequency of the fan reverse rotation in a case with a small demand for self-cleaning, saving electricity, being able to adapt to different scenarios and being more flexible.

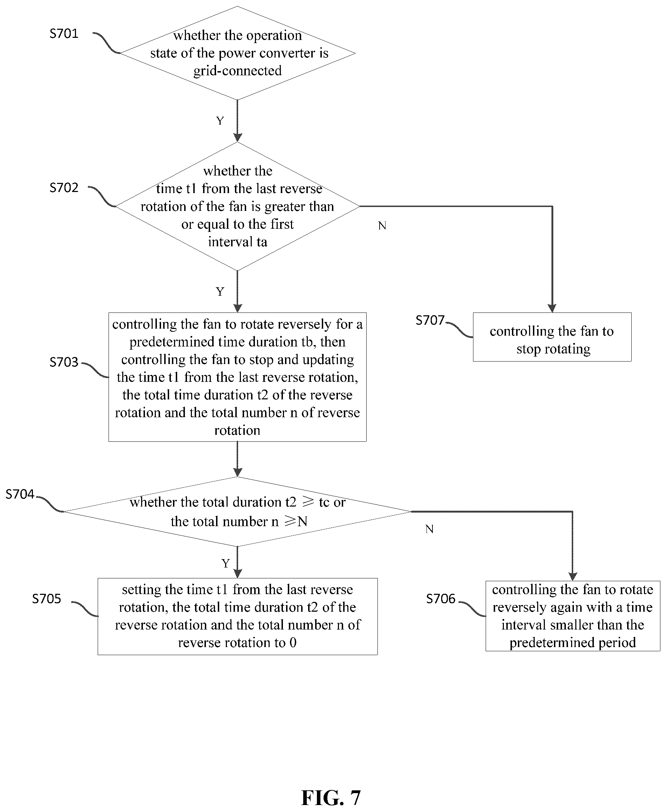

In another embodiment of the present application, a predetermined time duration tc or a predetermined number of times N can also be set for controlling the fan to perform multiple reverse rotation. Reference is made to FIG. 7, and FIG. 7 is a flowchart of a further method for automatically cleaning dust of a power converter provided according to the embodiment of the present application.

S701: determining whether the operation state of the power converter is grid-connected, and if the operation state of the power converter is grid-connected, performing step S702.

S702: determining whether the time t1 from the last reverse rotation of the fan is greater than or equal to the first interval ta, if t1is greater than or equal to ta, performing step S703; and if t1is less than ta, performing step S707.

S703: when the time t1 from the last reverse rotation of the fan is greater than or equal to the first interval ta, controlling the fan to rotate reversely for a predetermined time duration tb, then controlling the fan to stop and updating the time t1 from the last reverse rotation, the total time duration t2 of the reverse rotation and the total number n of the reverse rotation.

S704: determining whether the total time duration t2 of the reverse rotation is greater than or equal to the predetermined time duration tc or the total number n of the reverse rotation is greater than or equal to the predetermined number of times N, if t2 is greater than or equal to tc or n is greater than or equal to N, performing step S705; and if t2 is less than tc or or n is less than N, performing step S706.

S705: when the total time duration t2 of the reverse rotation is greater than or equal to the predetermined time duration tc or the total number n of the reverse rotation is greater than or equal to the predetermined number of times N, setting the time t1 from the last reverse rotation, the total time duration t2 of the reverse rotation and the total number n of reverse rotation to 0.

S706: when the total time duration t2 of the reverse rotation is less than the predetermined time duration tc or the total number n of the reverse rotation is less than the predetermined number of times N, controlling the fan to rotate reversely again with a time interval smaller than the predetermined period.

S707: controlling the fan to stop rotating.

With the method provided according to the above embodiment, multiple reverse rotation can also be implemented during the process of reverse rotation, that is, when the total time duration of the reverse rotation and/or the total number of the reverse rotation have not been reached, multiple reverse rotation of the fan can be performed within a shorter interval without waiting for the next period for reverse rotation to arrive, making it easier to remove foreign object and improving the efficiency of automatic cleaning.

With the description of the embodiments disclosed above, those skilled in the art may implement or use the present application. Various modifications made to the embodiments are apparent to those skilled in the art, and the general principles defined herein may be implemented in other embodiments without departing from the spirit or scope of the present application. Therefore, the present application is not limited to the embodiments described herein, but should comply with the widest scope consistent with the principles and novel features disclosed herein.

## Claims

1. A power converter, comprising: a power semiconductor device, a heat sink, a fan and a controller; wherein
the heat sink includes a heat sink substrate and heat sink fins;
the power semiconductor device is fitted on the heat sink substrate;
an air inlet mesh, the fan, the heat sink and an air outlet mesh are arranged in sequence in a case of the power converter;
an air channel is formed between the fan and the heat sink and between the heat sink and the air outlet mesh; and
the controller is configured to, when the power converter is in a non-grid-connected state, control the fan to rotate reversely for self-cleaning of the power converter.

2. The power converter according to claim 1, wherein the controller is configured to control the fan to rotate reversely with a predetermined period to and predetermine a time duration for each reverse rotation.

3. The power converter according to claim 2, wherein the controller is configured to, when the time from the last reverse rotation of the fan is greater than or equal to a first interval, control the fan to rotate reversely for a predetermined time duration, then control the fan to stop rotating and update the time from the last reverse rotation of the fan.

4. The power converter according to claim 2, wherein the controller is configured to, when the total time duration of the fan reverse rotation is greater than or equal to a predetermined time duration, control the fan to rotate reversely with the predetermined period; when the total time duration of the fan reverse rotation is less than a predetermined time duration, control the fan to rotate reversely again with a time interval smaller than the predetermined period.

5. The power converter according to claim 2, wherein the controller is configured to, when the total number of the fan reverse rotation is greater than or equal to the predetermined number of times, control the fan to rotate reversely with the predetermined period; when the total number of the fan reverse rotation is less than the predetermined number of times, control the fan to rotate reversely again with a time interval smaller than the predetermined period.

6. The power converter according to claim 2, wherein the controller is configured to, when the total time duration of the fan reverse rotation is greater than or equal to a predetermined duration and the total number of the fan reverse rotation is greater than or equal to the predetermined number of times, control the fan to rotate reversely with the predetermined period; when the total time duration of the fan reverse rotation is less than a predetermined duration and the total number of the fan reverse rotation is less than the predetermined number of times, control the fan to rotate reversely again with a time interval smaller than the predetermined period.

7. The power converter according to any one of claims 1 to 6, wherein the controller is further configured to, when the inverter in the power converter is connected to grid, control the fan to rotate reversely according to the power and/or the current of the inverter.

8. The power converter according to any one of claims 1 to 6, wherein the controller is further configured to, when the power converter starts, control the fan to rotate reversely for consuming energy and determine whether the energy at the input terminal of the inverter meets the requirements for grid connection.

9. A method for automatically cleaning dust of a power converter, wherein the power converter comprises: a power semiconductor device, a heat sink and a fan; the heat sink comprises a heat sink substrate and heat sink fins; the power semiconductor device is fitted on the heat sink substrate; an air inlet mesh, the fan, the heat sink and an air outlet mesh are arranged in sequence in the box of the power converter; an air channel is formed between the fan and the heat sink and between the heat sink and the air outlet mesh;
wherein the method for automatically cleaning dust of a power converter comprises:
determining the operation state of the power converter; and
when the operation state of the power converter is non-grid-connected, controlling the fan to rotate reversely for self-cleaning of the power converter.

10. The method according to claim 9, wherein that controlling the fan to rotate reversely when the operation state of the power converter is non-grid-connected comprises:
when the operation state of the power converter is non-grid-connected, controlling the fan to rotate reversely with a predetermined period and predetermining a time duration for each reverse rotation.

11. The method according to claim 10, wherein controlling the fan to rotate reversely comprises:
when the time from the last reverse rotation of the fan is greater than or equal to a first interval, controlling the fan to rotate reversely for a predetermined time duration, then controlling the fan to stop rotating and updating the time from the last reverse rotation of the fan.

12. The method according to claim 10, wherein controlling the fan to rotate reversely comprises:
when the total time duration of the fan reverse rotation is greater than or equal to a predetermined time duration, controlling the fan to rotate reversely with the predetermined period; and
when the total time duration of the fan reverse rotation is less than a predetermined time duration, controlling the fan to rotate reversely again with a time interval smaller than the predetermined period.

13. The method according to claim 10, wherein controlling the fan to rotate reversely comprises:
when the total number of the fan reverse rotation is greater than or equal to the predetermined number of times, controlling the fan to rotate reversely with the predetermined period; and
when the total number of the fan reverse rotation is less than the predetermined number of times, controlling the fan to rotate reversely again with a time interval smaller than the predetermined period.

14. The method according to claim 10, wherein controlling the fan to rotate reversely comprises:
when the total time duration of the fan reverse rotation is greater than or equal to a predetermined time duration and the total number of the fan reverse rotation is greater than or equal to the predetermined number of times, controlling the fan to rotate reversely with the predetermined period; and
when the total time duration of the fan reverse rotation is less than a predetermined time duration and the total number of the fan reverse rotation is less than the predetermined number of times, controlling the fan to rotate reversely again with a time interval smaller than the predetermined period.

15. The method according to any one of claims 9 to 14, further comprising:
when the inverter in the power converter is connected to the grid, controlling the fan to rotate reversely according to the power and/or current of the inverter.

16. The method according to claim 15, wherein controlling the fan to rotate reversely according to the power and/or the current of the inverter comprises:
when the power of the inverter is less than a predetermined power and/or the current of the inverter is less than a predetermined current, controlling the fan to rotate reversely.

17. The method according to any one of claims 9 to 14, further comprising:
when the power converter starts, controlling the fan to rotate reversely for consuming energy and determining whether the energy at the input terminal of the inverter meets the requirements for grid connection.
